# EUROPEAN PATENT APPLICATION

(11) **EP 4 411 216 A1**
(43) Date of publication of application: **07.08.2024**
(21) Application number: 22919914.6
(22) Date of filing: 07.11.2022
(51) Int. Cl.: F21V 13/08, F21V 9/00, H01L 33/64, H01S 5/024, F21V 29/00

(54) **LASER LIGHT SOURCE DEVICE, AND ILLUMINATION SYSTEM**

(30) Priority: 12.01.2022 CN 202220103359 U
(71) Applicant: YLX Incorporated, Shenzhen, Guangdong 518000 (CN)
(72) Inventor: CHEN, Bin, Shenzhen, Guangdong 518000 (CN); CHEN, Yongzhuang, Shenzhen, Guangdong 518000 (CN); QIU, Hanliang, Shenzhen, Guangdong 518000 (CN)
(74) Representative: Noréns Patentbyrå AB
(86) International application number: PCT/CN2022/130304
(87) International publication number: WO 2023/134280

(57) **Abstract**

The present disclosure provides a laser light source device and an illumination system, which include a housing provided with an opening, a wavelength conversion component covering or embedded in the opening to seal the opening to form an airtight space with the housing, and at least one laser provided in the airtight space and configured to generate laser light. The laser light is projected to the wavelength conversion component to generate exiting light. With the above method, the present disclosure increase the utilization rate of the laser light source.

## Description

### TECHNICAL FIELD

The present disclosure relates to the technical field of optics, in particular to relate to a laser light source device and an illumination system.

### BACKGROUND

In a common laser light source device, a laser and a wavelength conversion component are integrally packaged in a housing, and the laser light source device has the advantages of small size and convenient application. However, due to the size limitation of the laser light source device, the exiting light generated by the laser excited by the wavelength conversion component cannot be fully utilized, resulting in waste of resources.

### SUMMARY

In view of the above technical problems, the present disclosure provides a laser light source device, which can improve the utilization rate of a laser light source.

In order to solve the technical problem, the present disclosure provides a laser light source device. The laser light source device includes a housing, a wavelength conversion component, and at least one laser. The housing is provided with an opening. The wavelength conversion component covers or is embedded in the opening to seal the opening and form an airtight space with the housing. The at least one laser is provided in the airtight space and configured to generate laser light, and the laser light is projected to the wavelength conversion component to generate exiting light.

In some embodiments, the wavelength conversion component includes a transparent heat sink and a wavelength conversion member, and the transparent heat sink and the wavelength conversion member are sequentially arranged along an optical path of the laser light.

In some embodiments, the wavelength conversion component includes an antireflection coating or a dichroic film, the antireflection coating is provided at a side of the transparent heat sink opposite to the wavelength conversion member, and the dichroic film is provided between the transparent heat sink and the wavelength conversion member.

In some embodiments, the laser light source device includes a reflective component, the reflective component is provided in an airtight space and located on an optical path of the laser light, and the laser light is projected to the wavelength conversion component through the reflective component.

In some embodiments, the laser light source device includes a diffuser sheet, and the diffuser sheet is provided in the airtight space and located between the reflective component and the wavelength conversion component.

In some embodiments, the laser light source device includes a light-converging element, and the light-converging element is provided in the airtight space and located on an optical path of the laser light and configured to reduce a divergence angle of the laser light.

In some embodiments, the housing includes a base, the at least one laser is provided on the base, and a side surface of the housing opposite to the base is provided with the opening.

In some embodiments, the laser light source device includes a laser heat sink, the laser heat sink is provided in the airtight space, the at least one laser is fixed on the base through the laser heat sink, and the laser is parallel or perpendicular to the base, or is inclined relative to the base.

In some embodiments, the laser light source device includes a thermal conductive member, and the thermal conductive member is in thermal contact with the wavelength conversion component.

In some embodiments, the thermal conductive member is in thermal contact with both the wavelength conversion component and the base.

In some embodiments, the at least one laser comprises at least two lasers provided in the airtight space, and light spots of laser light generated by the at least two lasers projected to the wavelength conversion component at least partially overlap.

In order to solve the above technical problem, the present disclosure provides an illumination system, the illumination system includes the above laser light source device.

The present disclosure has the following beneficial effects. Different from the related art, the laser light source device in the present disclosure is provided with the opening in the housing, and the wavelength conversion component is embedded in the opening to seal the opening, so that the wavelength conversion component may excite laser light projected by the laser on the housing to generate fluorescence. In this way, the surface where the fluorescence is excited by the wavelength conversion component can directly serve as the light-exiting surface of the exiting light, so that all fluorescence excited by the wavelength conversion component can be emitted as the exiting light, thereby improving the utilization rate of the fluorescence. The wavelength conversion component is used as a part for sealing the housing without providing the wavelength conversion component in the housing, so that the size of the laser light source device and the cost are reduced. The wavelength conversion component is embedded in the opening to form an enclosed space with the housing, which does not affect the tightness of the laser light source device and ensures the reliability of the laser light source device.

### BRIEF DESCRIPTION OF DRAWINGS

FIG. 1 is a side-view sectional schematic diagram of a laser light source device according to a first embodiment of the present disclosure;
FIG. 2 is a side-view sectional schematic diagram of a laser light source device according to a second embodiment of the present disclosure;
FIG. 3 is a side-view sectional schematic diagram of a laser light source device according to a third embodiment of the present disclosure;
FIG. 4 is a side-view sectional schematic diagram of a laser light source device according to a fourth embodiment of the present disclosure;
FIG. 5 is a side-view sectional schematic diagram of a laser light source device according to a fifth embodiment of the present disclosure;
FIG. 6 is a side-view sectional schematic diagram of a laser light source device according to a sixth embodiment of the present disclosure;
FIG. 7 is a side-view sectional schematic diagram of a laser light source device according to a seventh embodiment of the present disclosure;
FIG. 8 is a side-view sectional schematic diagram of a laser light source device according to an eighth embodiment of the present disclosure;
FIG. 9 is a side-view sectional schematic diagram of a laser light source device according to a ninth embodiment of the present disclosure;
FIG. 10 is a side-view sectional schematic diagram of a laser light source device according to a tenth embodiment of the present disclosure;
FIG. 11 is a side-view sectional schematic diagram of a laser light source device according to an eleventh embodiment of the present disclosure;
FIG. 12 is a side-view sectional schematic diagram of a laser light source device according to a twelfth embodiment of the present disclosure;
FIG. 13 is a side-view sectional schematic diagram of a laser light source device according to a thirteenth embodiment of the present disclosure;
FIG. 14 is a side-view sectional schematic diagram of a laser light source device according to a fourteenth embodiment of the present disclosure; and
FIG. 15 is a side-view sectional schematic diagram of a laser light source device according to a fifteenth embodiment of the present disclosure.

### DESCRIPTION OF EMBODIMENTS

The technical solutions in the embodiments of the present disclosure will be described clearly and completely below in combination with the drawings in the embodiments of the present disclosure. The described embodiments are only some of the embodiments of the present disclosure, rather than all of them. All other implementations, based on the implementations of the present disclosure, obtained by those skilled in the art shall fall within the scope of the present disclosure. The "first" and "second" described in the present disclosure do not represent a sequence, and are just used for indication. The "and/or" described in the present disclosure is only used to describe the associated relationship of the associated objects, indicating that three relationships, and is not used to limit the associated relationship.

In a laser light source device, a wavelength conversion member of the laser light source device is generally provided in a housing. Although such configuration makes the overall structure of the laser light source device more compact, the distance between the light-exiting surface of the light source device and the wavelength conversion member (such as the fluorescent sheet) is relatively long, and thus the exiting light has a relatively large divergence angle before being projected to the light-exiting surface. Due to the size of the light-exiting surface, only a part of the light can be emitted through the light-exiting surface, thereby reducing the utilization rate of the exiting light.

In view of the above technical problems, the present disclosure provides the following embodiments.

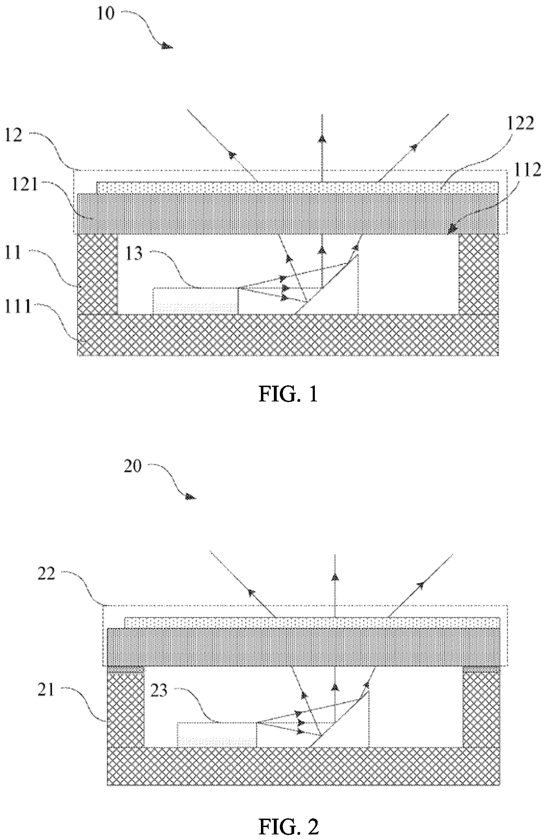

FIG. 1 is a side-view sectional diagram of a laser light source device according to a first embodiment of the present disclosure. As shown in FIG. 1, in this embodiment, the laser light source device 10 includes a housing 11, a wavelength conversion component 12, and a laser 13.

For example, in this embodiment, the housing 11 is provided with an opening 112, and the wavelength conversion component 12 covers or is embedded in the opening 112 to seal the opening 112 and form an airtight space with the housing 11, the laser 13 is provided in the airtight space and configured to generate laser light, and the laser light is projected to the wavelength conversion component 12 to generate exiting light.

In some embodiments, the wavelength conversion component 12 includes a transparent heat sink 121 and a wavelength conversion member 122, and the transparent heat sink 121 and the wavelength conversion member 122 are sequentially arranged along an optical path of the laser light.

In this embodiment, the laser light generated by the laser 13 may be projected to the transparent heat sink 121, and the thickness of the transparent heat sink 121 is not limited herein. The transparent heat sink 121 and the wavelength conversion member 122 are sequentially arranged along the optical path of the laser light, and the laser light projected to the transparent heat sink 121 can transmit through the transparent heat sink 121 and then is projected to the wavelength conversion member 122, thereby the wavelength conversion member 122 can perform wavelength conversion on the projected laser light to form the exiting light.

For example, in some embodiments, the wavelength conversion member 122 may be a fluorescent powder layer coated on the transparent heat sink 121, or a fluorescent sheet covering the transparent heat sink 121, or the like, which is not limited herein.

The transparent heat sink 121 may transmit a laser beam, and a material of the transparent heat sink 121 may be flexibly provided according to requirements, for example, the transparent heat sink 121 is a sapphire material whose thermal conductivity is relatively large, which can increase a heat dissipation speed.

In some embodiments, the wavelength conversion component 12 includes an antireflection coating or a dichroic film (not shown in drawings), the antireflection coating may be provided at a side of the transparent heat sink 121 opposite to the wavelength conversion member 122, and the dichroic film may be provided between the transparent heat sink 121 and the wavelength conversion member 122.

For example, the antireflection coating transmissive to a laser beam may be provided on a surface of the transparent heat sink 121 facing towards the laser 13, or the dichroic film may be provided between the transparent heat sink 121 and the wavelength conversion member 122, and both the antireflection coating and the dichroic film may transmit laser light and reflect fluorescence to increase a conversion rate of the laser light.

In some embodiments, the housing 11 includes a base 111, the laser 13 is provided on the base 111, and a side surface of the housing 11 opposite to the base 111 is provided with the opening 112.

For example, in some embodiments, the opening 112 may has a size equal to the traversal area of the zone encompassed by the side walls of the housing 11, the wavelength conversion component 12 may cover the opening 112 and be fixedly and hermetically connected to the side wall of the housing 11, the wavelength conversion component 12 and the base 111 form two opposite side walls of the housing 11, and the wavelength conversion component 12 and the housing 11 may be air-tightly connected to each other by a sealing material, so as to ensure the laser chip to work reliably for a long time. The sealing material may be glass, tin solder, glue, gold tin, or the like.

In some embodiments, as shown in FIG. 1, the sealing material may be a thin layer of material on an interface between the wavelength conversion component 12 and the housing 11, and may completely cover the interface between the wavelength conversion component 12 and the housing 11, or may partially cover the interface between the wavelength conversion component 12 and the housing 11; or may be provided on a side wall of the housing 11 corresponding to the interface, or provided in a filling groove (not shown in drawings) in the wavelength conversion component 12 so that the sealing material in the filling groove may be used to air-tightly connect the wavelength conversion component 12 with the housing 11 when the wavelength conversion component 12 abuts against the housing 11.

In some embodiments, in the above application scenario, the arrangement of the sealing material does not affect the interface where the wavelength conversion component 12 abuts against the housing 11, and in other application scenarios, the airtight space formed by the wavelength conversion component 12 and the housing 11 through the sealing material is not limited to the above methods.

FIG. 2 is a side-view sectional diagram of a laser light source device according to a second embodiment of the present disclosure. In some embodiments, as shown in FIG. 2, in a laser light source device 20 of the present embodiment, the configurations of a wavelength conversion component 22, a housing 21 and a laser 23 may be respectively the same as the configurations of the wavelength conversion component, the housing, and the laser that are presented in the first embodiment, and details are not repeated herein. Different from the first embodiment, the sealing material suitable for the airtight connection between the wavelength conversion component 22 and the housing 21 in this embodiment has a relatively large thickness, and is spread on the interface where the wavelength conversion component 22 abuts against the housing 21. The thickness and sealing material are not limited herein. For example, in some embodiments, the wavelength conversion component 22 and the housing 21 may not directly abut against each other to achieve airtight connection, but instead are air-tightly connected by using a sealing material, and technical effects are the same as those presented in the previous embodiment, and details are not repeated herein.

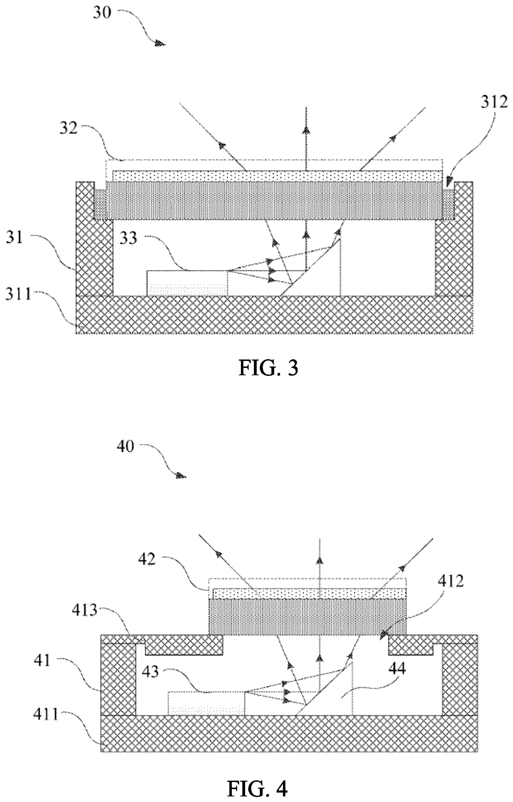

In some embodiments, in some application scenarios, the wavelength conversion component may also be embedded in the opening and fixedly and hermetically connected to the side wall of the housing. FIG. 3 is a side-view sectional diagram of a laser light source device according to a third embodiment of the present disclosure.

As shown in FIG. 3, in the laser light source device 30, by adjusting the size of the wavelength conversion component 32, the wavelength conversion component 32 can abut against a surface of the side wall of the housing 31 facing towards the airtight space, and the airtight connection between the wavelength conversion component 32 and the housing 31 is realized through the airtight connection method presented in the first embodiment.

In some embodiments, in some application scenarios, a step may be provided on a vertical side wall of the base 311 to form a stepped opening 312, and the wavelength conversion component 32 is provided in a stepped groove formed by the step, and a surface of the wavelength conversion component 32 facing towards the base 311 may abut against the side wall of the housing 31, or a side surface of the wavelength conversion component 32 perpendicular to the base 311 may abut against the side wall of the housing 31, or both a bottom surface and a side surface of the wavelength conversion component 32 may abut against the side wall to form an airtight space with the housing 31.

In some embodiments, an airtight material may be provided between the bottom surface of the wavelength conversion component 32 and the side wall of the housing 31, or an airtight material may be provided between the side surface of the wavelength conversion component 32 and the side wall of the housing 31, or an airtight material may be provided between the bottom surface of the wavelength conversion component 32 and the side wall of the housing 31 and also provided between and the side surface of the wavelength conversion component 32 and the side wall of the housing 31, which can be flexibly adjusted according to specific application scenarios and not limited herein.

In this embodiment, other configurations of the laser 33 and the wavelength conversion component 32 may be respectively the same as the configurations of the laser and the wavelength conversion component that are presented in the above embodiments, and details are not repeated herein.

In some embodiments, in some application examples, the housing may include a base and a cover, the cover and the base are provided at two opposite side walls of the housing, respectively, and the opening may be provided in the cover. FIG. 4 is a side-view sectional diagram of a laser light source device according to a fourth embodiment of the present disclosure. As shown in FIG. 4, in the laser light source device 40 in this embodiment, the housing 41 includes a base 411 and a cover 413, the base 411 and the cover 413 are respectively provided at two opposite sides of the housing 41, the opening 412 is provided in the cover 413, and the wavelength conversion component 42 covers or is embedded in the opening 412 to seal the housing 41, to form an airtight accommodation space that may accommodate a laser 43 and a reflective component 44.

In this embodiment, the cover 413 may be a metal cover, and the metal cover and the housing 41 may be directly fused together by a process, such as a parallel seal welding process, or a resistance welding process, or a laser welding process.

The configuration of the laser 43 may be the same as the configuration of the laser presented in any one of the above embodiments, and details are not repeated herein.

In some embodiments, the laser light source device may include a reflective component, the reflective component is provided in the airtight space and located on an optical path of the laser light, and the laser light is projected to the wavelength conversion component through the reflective component.

Taking the fourth embodiment as an example, a reflective surface of the reflective component 44 may be provided to face towards a laser emergent end of the laser 43, and the laser light emitted by the laser 43 may be projected to the reflective surface of the reflective component 44. The laser 43 and the opening 412 are respectively provided at two opposite sides of the housing 41, and both the laser 43 and the reflective component 44 may be provided and fixed on the base 411, laser light generated by the laser 43 may be projected to the reflective surface of the reflective component 44, and the laser light reflected by the reflective surface exits towards the opening 412 opposite to the base 411, so that the reflected laser light may be projected to the wavelength conversion component 42, thereby realizing laser wavelength conversion.

In some embodiments, a vertical projection of the opening 412 on the base 411 may cover the reflective component 44, so that the laser light reflected by the reflective component 44 can be collected by the wavelength conversion component 42 more, thereby improving the conversion efficiency of the laser and reducing the waste of laser resources.

The reflective component 44 may be a reflective plane mirror, a total reflection prism, or a lens plated with a highly reflective metal surface, or may be a reflective element in other forms, and the reflective component 44 may be in a shape of a triangle shown in the figure, in other shapes as required.

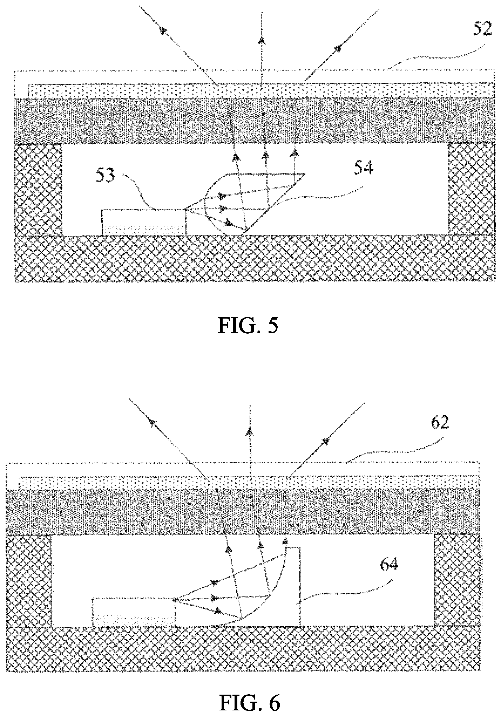

In some embodiments, FIG. 5 is a side-view sectional diagram of a laser light source device according to a fifth embodiment of the present disclosure.

As shown in FIG. 5, in this embodiment, the reflective component 54 may be a lens integrated with a reflector, a surface of the reflective component 54 close to the laser 53 may be a spherical surface or a cylindrical surface and is configured to reduce a divergence angle of the laser beam, and a surface for reflecting the laser light is an oblique surface and configured to reflect laser beam to the wavelength conversion component 52.

Other configurations in this embodiment may be respectively the same as the configurations presented in any one of the first to fourth embodiments, and details are not repeated herein.

In some embodiments, FIG. 6 is a side-view sectional diagram of a laser light source device according to a sixth embodiment of the present disclosure.

As shown in FIG. 6, in this embodiment, the reflective component 64 may be a concave reflector, a reflective surface for reflecting laser light is concave to converge a divergence angle of a laser beam and reflect the laser light to the wavelength conversion component 62. The reflective concave surface may be a spherical surface, an aspheric surface, a cylindrical surface, a parabolic concave surface, or the like, which is not limited herein.

Other configurations in this embodiment may be respectively the same as the configurations presented in any one of the first to fourth embodiments, and details are not repeated herein.

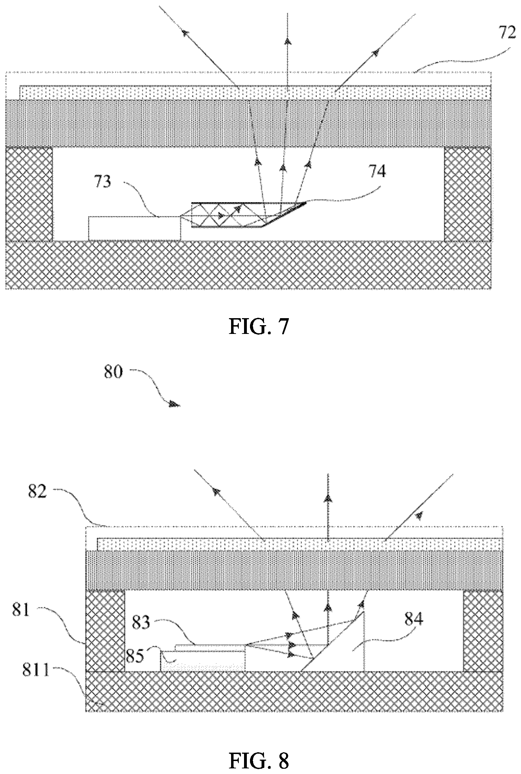

In some embodiments, FIG. 7 is a side-view sectional diagram of a laser light source device according to a seventh embodiment of the present disclosure.

As shown in FIG. 7, in this embodiment, the reflective component 74 may be a light guide, an oblique reflective surface is provided at an end of the light guide, and a light beam generated by the laser 73 is coupled into the light guide and then is reflected multiple times in the light guide, and then is reflected and emitted to the wavelength conversion component 72 at the end of the light guide.

The light guide may be a square light guide, a circular light guide, or an optical fiber. After the laser beam is reflected and propagated multiple times in the light guide, the laser beam is homogenized, so that light intensity of light spots of the laser light incident to the wavelength conversion component 72 is relatively uniform, which avoid the problem of fluorescence quenching.

Other configurations in this embodiment may be respectively the same as the configurations presented in any one of the first to fourth embodiments, and details are not repeated herein.

In some application examples, the laser light source device includes a laser heat sink, the laser heat sink is provided in an airtight space, at least one laser is fixed on the base through the laser heat sink, and the laser is parallel or perpendicular to the base, or is inclined relative to the base.

In some embodiments, FIG. 8 is a side-view sectional diagram of a laser light source device according to an eighth embodiment of the present disclosure. As shown in FIG. 8, in this embodiment, the laser light source device 80 includes a laser heat sink 85, the laser heat sink 85 is provided in the airtight space, and the at least one laser 83 is fixed on the base through the laser heat sink 85.

In this embodiment, the configurations of the wavelength conversion component 82, the housing 81, and the reflective component 84 may be respectively the same as the configurations of the wavelength conversion component, the housing, and the reflective component that are presented in any one of the above embodiments, and details are not repeated herein.

For example, in this embodiment, the laser heat sink 85 may be provided between the laser 83 and the base 811 and fixedly connected to the base 811, and the laser 83 is fixedly provided on a surface of the laser heat sink 85 facing away from the base 811, so that heat generated by the laser 83 may be conducted to the base 811 through the laser heat sink 85, and dissipated outside the housing 81 through the base 811, thereby improving heat dissipation performance of the laser light source device 80. The laser 83 is parallel to the base 811, that is, light generated by the laser 83 is parallel to the base 811.

In some application examples, the laser light source device includes a diffuser sheet, and the diffuser sheet is provided in the airtight space and located between the reflective component and the wavelength conversion component. In some embodiments, in order to ensure the diffusion effect of the diffusion sheet, a vertical projection of the diffusion sheet on the base may cover the reflective component, and in other application examples, the vertical projection of the diffusion sheet on the base may not completely cover the reflective component, which is not limited herein.

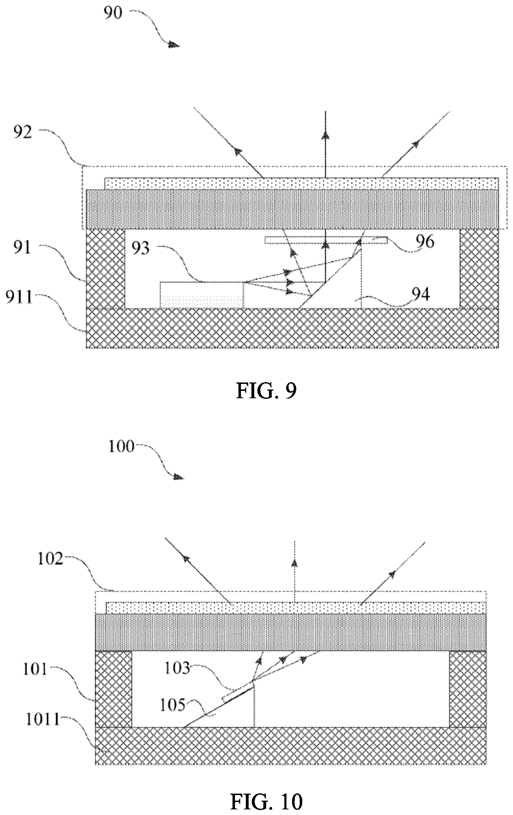

FIG. 9 is a side-view sectional diagram of a laser light source device according to a ninth embodiment of the present disclosure.

In this embodiment, the configurations of the housing 91, the wavelength conversion component 92, the laser 93 and the reflective component 94 in the laser light source device 90 may be respectively the same as the configurations of the housing, the wavelength conversion component, the laser, and the reflective component in the laser light source device that are presented in any one of the above embodiments, which is not limited herein.

For example, in this embodiment, a diffuser sheet 96 is provided in front of the wavelength conversion component 92 and the reflective component 94, and a vertical projection of the diffuser sheet 96 on the base 911 covers the reflective component 94. The diffuser sheet 96 is configured to expand a light spot of the laser light, and the diffuser sheet 96 may be elliptical Gaussian or circular Gaussian, and the diffuser sheet 96 may be inclined to change the shape of the light spot.

In some application examples, the laser light generated by the laser in the laser light source device may not be reflected, and may be directly projected to the wavelength conversion component to be converted into the exiting light. Referring to FIG. 10, FIG. 10 is a side-view sectional diagram of a laser light source device according to a tenth embodiment of the present disclosure.

As shown in FIG. 10, in this embodiment, the laser light generated by the laser 103 in the laser light source device 100 may be directly projected on the wavelength conversion component 102. In some embodiments, the laser heat sink 105 may be fixed on the base 1011, and the laser 103 may be provided on a surface of the laser heat sink 105 facing away from the base 1011, for example, a surface of the laser heat sink 105 facing away from the base 1011 may be an oblique surface, so that the laser 103 is inclined relative to the base 1011, so that a laser exiting end of the laser 73 fixed to the oblique surface faces towards an opposite side of the base 1011, thereby the laser light generated by the laser 103 may be directly projected on the wavelength conversion component 102 to form exiting light.

In this embodiment, the configurations of the housing 101 and the wavelength conversion component 102 may be respectively the same as the configurations of the housing and the wavelength conversion component that are presented in any one of the above embodiments, and details are not repeated herein.

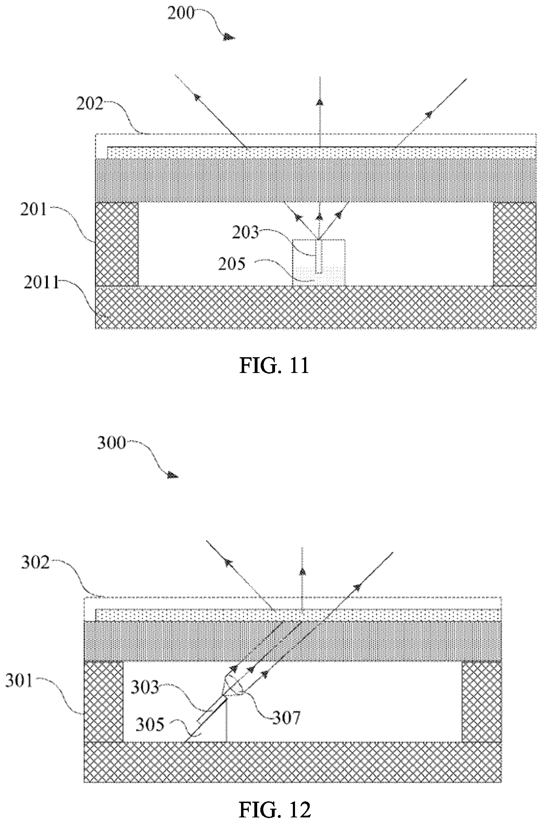

FIG. 11 is a side-view sectional diagram of a laser light source device according to an eleventh embodiment of the present disclosure. As shown in FIG. 11, in the laser light source device 200 provided in this embodiment, the laser heat sink 205 is fixed on the base 2011, the laser 203 may be fixed on a side surface of the laser heat sink 205 perpendicular to the base 2011, or may be embedded in the laser heat sink 205 in a direction perpendicular to the base 2011, so that a laser exiting end of the laser 203 faces towards the wavelength conversion component 202, that is, making the laser 203 be perpendicular to the base 2011, thereby leading the laser light generated by the laser 203 to be directly projected on the wavelength conversion component 202 to form exiting light.

In this embodiment, the configurations of the housing 201 and the wavelength conversion component 202 may be respectively the same as the configurations of the housing and the wavelength conversion component that are presented in any one of the above embodiments, and details are not repeated herein.

In some application examples, the laser light source device may include a light-converging element, and the light-converging element is provided in the airtight space and located on an optical path of the laser light and configured to reduce a divergence angle of the laser light.

FIG. 12 is a side-view sectional diagram of a laser light source device according to a twelfth embodiment of the present disclosure. As shown in FIG. 12, the laser light source device 300 includes a light-converging element 307, the light-converging element 307 may be provided at a laser exiting end of the laser 303, laser light generated by the laser 303 is projected to the light-converging element 307 first, the light-converging element 307 may reduce a divergence angle of the laser light, and the laser light transmitted by the light-converging element 307 is projected on the wavelength conversion component 302 to form exiting light.

The light-converging element 307 may be a light converging lens, a cylindrical mirror, or the like, and the divergence angle of the laser light is adjusted by the light-converging element 307 to obtain an exiting light spot with a target shape and size, and the selection of the light-converging element 307 may be flexibly provided according to the requirements of the exiting light spot, which is not limited herein.

In this embodiment, the configurations of the wavelength conversion component 302, the housing 301, the laser heat sink 305, and the laser 303 may be respectively the same as the configurations of the wavelength conversion component, the housing, the laser heat sink, and the laser that are presented in any one of the above embodiments, and details are not repeated herein. In addition to the configuration of the light-converging element 307 presented in this embodiment, the light-converging element 307 may be provided at another position on an optical path from the laser light generated by the laser 303 to the wavelength conversion component 302. In addition to this embodiment, all other embodiments of the present disclosure may be provided with the light-converging element 307.

In some application examples, the laser light source device includes a thermal conductive member, and the thermal conductive member is in thermal contact with the wavelength conversion component and provided in the airtight space, and abuts against both the wavelength conversion component and the base, and is provided out of the optical path of the laser light.

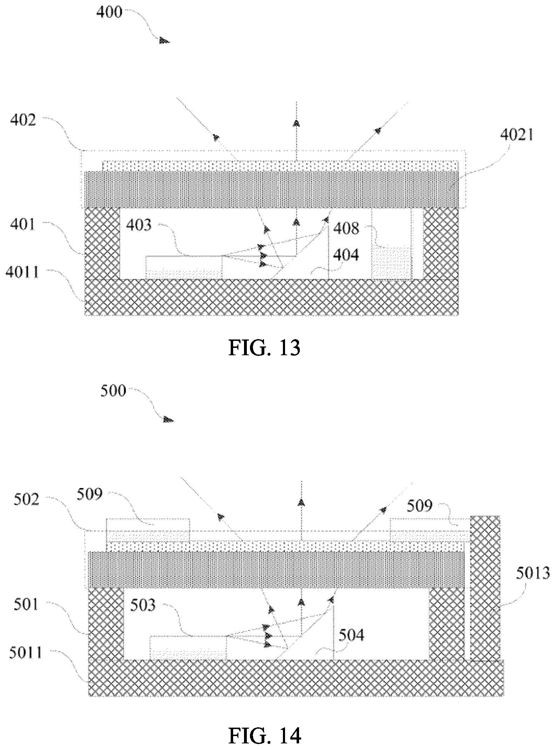

FIG. 13 is a side-view sectional diagram of a laser light source device according to a thirteenth embodiment of the present disclosure.

As shown in FIG. 13, in the present embodiment, the laser light source device 400 includes a thermal conductive member 408, and the thermal conductive member 408 abuts against, in the airtight space, a surface of the wavelength conversion component 402 and a surface of the base 4011 opposite to the surface of the wavelength conversion component 402, so as to conduct heat generated by the wavelength conversion component 402 to the base 4011 through the thermal conductive member 408, so that the heat generated by the wavelength conversion component 402 can be conducted out through the base 4011 to prevent the overall temperature of the laser light source device 400 from being too high to affect its reliability. The thermal conductive member 408 is provided out of the optical path of the laser light, which does not shield the optical path of the laser light projected to the wavelength conversion component 402.

The configurations of the laser 403, the housing 401 and the wavelength conversion component 402 may be respectively the same as the configurations of the laser, the housing, and the wavelength conversion component that are presented in any one of the above embodiments, and details are not repeated herein.

In some embodiments, in some application settings, the thermal conductive member may also be in thermal contact with both the wavelength conversion component and the base, the laser light source device includes a heat dissipation block, and the heat dissipation block is provided on the light-exiting surface of the exiting light and is out of the optical path of the exiting light.

FIG. 14 is a side-view sectional diagram of a laser light source device according to a fourteenth embodiment of the present disclosure.

As shown in FIG. 14, in this embodiment, the laser light source device 500 includes at least one heat dissipation block 509, and the at least one heat dissipation block 509 is provided on a surface of the wavelength conversion component 502 away from the base 5011 and does not shield an optical path of the exiting light, and does not affect the light spot of the exiting light. In some embodiments, the housing 501 may be provided with a protrusion 5013 connecting the heat dissipation block 509 and the base 5011. In some embodiments, the heat generated by the wavelength conversion component 502 may be conducted to the base 5011 through the heat dissipation block 509 and the protrusion 5013, thereby preventing the temperature of the wavelength conversion component 502 from being too high to affect its reliability.

In this embodiment, the configurations of the laser 503, the reflective component 504, and other elements may be respectively the same as the configurations of the laser, the reflective component, and other elements that are presented in any one of the above embodiments, and details are not repeated herein.

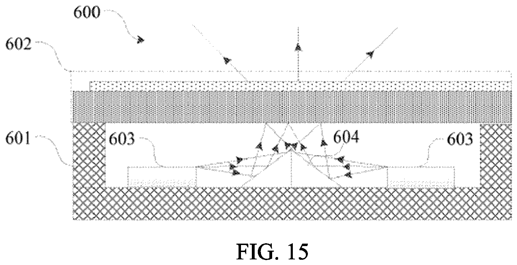

In some embodiments, at least two lasers are provided in the airtight space of the laser light source device, and light spots of the laser light generated by the at least two lasers projected to the wavelength conversion component at least partially overlap. FIG. 15 is a side-view sectional diagram of a laser light source device according to a fifteenth embodiment of the present disclosure.

As shown in FIG. 15, in this embodiment, the number of the lasers 603 may be two, the reflective component 604 may include two reflective surfaces or two reflective elements, and the two reflective surfaces or the two reflective elements are in one-to-one correspondence with the two lasers 603 and each can reflect the laser light generated by the corresponding laser 603 to the wavelength conversion component 602 to form the exiting light.

In some application examples, the laser light generated by multiple lasers 603 is reflected by the reflective component 604 and then projected to the wavelength conversion component 602, and when the laser light generated by different lasers 603 is correspondingly projected to the wavelength conversion component 602, different light spots corresponding to different lasers 603 may overlap, or may partially overlap, or may not overlap at all, and a required shape of a light spot of the exiting light may be combined according to actual application requirements, thereby increasing flexibility of an application scenario of the laser light source device 600.

The configurations of the housing 601 and the wavelength conversion component 602 may be respectively the same as the configurations of the housing and the wavelength conversion component that are presented in any one of the above embodiments, and details are not repeated herein.

In any one of the above embodiments, an electrode (not shown) of at least one laser is connected to an electrode (not shown) of the housing.

An external interface of the electrode of the housing and a thermal conduction external surface of the laser may be located on one plane, the external interface of the electrode of the housing may be provided on a side surface of the housing.

In view of the above, in the present disclosure, the wavelength conversion component is provided on the housing, so that the fluorescence converted by the wavelength conversion component may be directly emitted out without passing through the housing, which can reduce the reflection of the exiting light and increase the utilization rate of the laser light source. In the present disclosure, the wavelength conversion component and the housing are provided together to form the airtight space, so that the reliability of the laser light source device can be improved. In the present disclosure, the wavelength conversion component is provided out of the airtight space, so that the volume of the airtight space can be reduced, and the compactness of the overall structure of the laser light source device is increased.

In some specific application examples, the present disclosure provides an illumination system including at least one laser light source device according to any one of the above embodiments. The illumination system can be used for daily illumination, projection, or the like, and is not limited to a projector, a stage light, a vehicle lamp, a flashlight, a searchlight and the like.

The above merely illustrates implementations of the present disclosure, and is not intended to limit the patent scope of the present disclosure, and any transformation of equivalent structure or equivalent process made according to the specification and accompanying drawings of the present disclosure, or other directly or indirectly applications to related technical fields, are also fall within the scope of the present disclosure.

## Claims

1. A laser light source device, comprising:
a housing provided with an opening;
a wavelength conversion component covering or embedded in the opening to seal the opening and form an airtight space with the housing; and
at least one laser provided in the airtight space and configured to generate laser light, wherein the laser light is projected to the wavelength conversion component to generate exiting light.

2. The laser light source device according to claim 1, wherein the wavelength conversion component comprises a transparent heat sink and a wavelength conversion member, wherein the transparent heat sink and the wavelength conversion member are sequentially arranged along an optical path of the laser light.

3. The laser light source device according to claim 2, wherein the wavelength conversion component comprises an antireflection coating or a dichroic film, wherein the antireflection coating is provided at a side of the transparent heat sink away from the wavelength conversion member, and the dichroic film is provided between the transparent heat sink and the wavelength conversion member.

4. The laser light source device according to claim 1, further comprising:
a reflective component provided in the airtight space and located on an optical path of the laser light, wherein the laser light is projected to the wavelength conversion component through the reflective component.

5. The laser light source device according to claim 4, further comprising:
a diffuser sheet provided in the airtight space and located between the reflective component and the wavelength conversion component.

6. The laser light source device according to claim 1, further comprising:
a light-converging element provided in the airtight space, located on an optical path of the laser light, and configured to reduce a divergence angle of the laser light.

7. The laser light source device according to any one of claims 1 to 6, wherein the housing comprises a base, the at least one laser is provided on the base, and a side surface of the housing opposite to the base is provided with the opening.

8. The laser light source device according to claim 7, further comprising:
a laser heat sink provided in the airtight space, wherein the at least one laser is fixed on the base through the laser heat sink and is parallel or perpendicular to the base, or is inclined relative to the base.

9. The laser light source device according to claim 1, further comprising:
a thermal conductive member in thermal contact with the wavelength conversion component.

10. The laser light source device according to claim 9, wherein the thermal conductive member is in thermal contact with both the wavelength conversion component and the base.

11. The laser light source device according to claim 1, wherein the at least one laser comprises at least two lasers provided in the airtight space, and light spots of laser light generated by the at least two lasers projected to the wavelength conversion component at least partially overlap.

12. An illumination system comprising at least one laser light source device, wherein the at least one laser light source device each is the laser light source device according to any one of claims 1 to 11.
